# FASCICULE DE BREVET EUROPEEN

(11) **EP 3 836 235 B1**
(45) Date de publication et mention de la délivrance du brevet: **24.08.2022**
(21) Numéro de dépôt: 20211084.7
(22) Date de dépôt: 01.12.2020
(51) Int. Cl.: H01L 33/00, H01L 21/02, H01L 21/033, H01L 21/308, H01L 21/311

(54) **PROCEDE DE REALISATION D'UNE COUCHE DE MATERIAU STRUCTUREE**
VERFAHREN ZUM AUFBRINGEN EINER STRUKTURIERTEN MATERIALSCHICHT
METHOD FOR MANUFACTURING A LAYER OF STRUCTURED MATERIAL

(30) Priorité: 11.12.2019 FR 1914172
(43) Date de publication de la demande: 16.06.2021
(73) Titulaire: Commissariat à l'énergie atomique et aux énergies alternatives, 75015 Paris (FR)
(72) Inventeur: GASSE, Adrien, 38054 Grenoble CEDEX 09 (FR); DUSSAIGNE, Amélie, 38054 Grenoble CEDEX 09 (FR); LEVY, François, 38054 Grenoble CEDEX 09 (FR)
(74) Mandataire: Brevalex

(56) Documents cités:
- EP-A1- 2 466 652
- WO-A1-2018/060570
- US-A1- 2008 008 969
- US-A1- 2017 338 114
- US-A1- 2017 365 485

## Description

### DOMAINE TECHNIQUE

L'invention concerne la réalisation de structurations, ou texturations, dans une couche de matériau correspondant avantageusement à une couche de semi-conducteur III-V ou faisant avantageusement partie d'un empilement de couches comprenant une couche de semi-conducteur III-V. L'invention s'applique avantageusement à la réalisation de dispositifs semi-conducteurs émissifs tels que des diodes électroluminescentes, ou LEDs, comprenant du semi-conducteur III-V, et dans lesquels les structurations forment des éléments ou motifs d'extraction de la lumière produite par les dispositifs.

### ÉTAT DE LA TECHNIQUE ANTÉRIEURE

Il est connu de réaliser des LEDs à partir de substrats de type GaNOS (« GaN On Sapphire » en anglais, ou GaN sur saphir) ou InGaNOS (« InGaN On Sapphire » en anglais, ou InGaN sur saphir), c'est-à-dire comprenant du GaN ou des îlots d'InGaN sur un substrat de saphir. Un problème rencontré avec de telles LEDs, ainsi qu'avec n'importe quelle LED réalisée avec du GaN ou de l'InGaN, est que le GaN et l'InGaN formant les matériaux émissifs de ces LEDs sont des matériaux ayant des indices de réfraction élevés qui diffèrent beaucoup de celui du milieu dans lequel fonctionnent les LEDs (air ou matériau encapsulant tel qu'un polymère). Une partie importante de la lumière produite par ces LEDs reste donc piégée dans le GaN ou l'InGaN et n'est pas émise. Ce problème est encore plus important lorsque des substrats de type GaNOS ou InGaNOS sont utilisés du fait que des photons sont également piégés dans les couches d'oxyde et les couches de saphir de ces substrats.

L'extraction de la lumière produite par les LEDs peut être améliorée en utilisant des substrats de saphir structurés, également appelés PSS pour « Patterned Sapphire Substrate ».

Cette extraction de la lumière peut être encore améliorée en réalisant une structuration, ou texturation, du GaN ou de l'InGaN des LEDs. Une telle structuration du GaN ou de l'InGaN est généralement réalisée par lithographie, à la fin de la réalisation des composants. La mise en œuvre de cette structuration est toutefois problématique pour des raisons d'alignement, de compatibilité avec les métaux de contacts ou encore des risques d'endommagement. De plus, dans le cas des substrats GaNOS ou InGaNOS, l'épaisseur de semi-conducteur à structurer est faible (typiquement < 1 µm), ce qui rend critique les opérations de photolithographie classique.

De manière alternative, le document « Enhancement of light extraction from GaN-based green light-emitting diodes using selective area photonic crystal » de J.Y. Kim et al., Applied Physics Letters 96, 251103, 2010, propose de réaliser une structuration d'une couche de GaN de LEDs via une lithographie de type « nanoimprint ». De même que la photolithographie, cette technique nécessite un alignement critique sur les composants réalisés. De plus, l'emploi d'une force importante pour structurer les résines risque également d'endommager les composants réalisés.

EP 2466652 A1 divulgue un procédé de réalisation de diodes électroluminescentes, comportant la mise en oeuvre d'un procédé de réalisation d'une couche de matériau structurée, comprenant les étapes de réalisation d'un premier substrat comportant au moins une face structurée, réalisation, contre la face structurée du premier substrat, d'un empilement de couches comprenant au moins la couche de matériau structurée, tel qu'une première face de la couche de matériau structurée disposée du côté de la face structurée du premier substrat soit structurée conformément à un motif inverse de celui de la face structurée du premier substrat, et retrait du premier substrat.
US 2017/0338114 A1 divulgue un procédé de réalisation d'une couche de matériau structurée.

Les problèmes exposés ci-dessus se retrouvent également lorsqu'une structuration doit être réalisée dans une couche de semi-conducteur III-V autre que du GaN ou de l'InGaN, et plus généralement dans une couche de matériau.

### EXPOSÉ DE L'INVENTION

Un but de la présente invention est de proposer un procédé de réalisation d'au moins une couche de matériau structurée ne présentant pas les inconvénients mentionnés précédemment, notamment ceux liés à la mise en œuvre d'une étape de lithographie, et qui ne nécessite pas de réaliser un alignement entre ces structurations et les dispositifs réalisés avec une telle couche structurée.

Pour cela, la présente invention propose un procédé de réalisation d'au moins une couche de matériau structurée, comprenant au moins les étapes suivantes :
- réalisation d'un premier substrat comportant au moins une face structurée ;
- réalisation, contre la face structurée du premier substrat, d'un empilement de couches comprenant au moins une couche intermédiaire et la couche de matériau destinée à être structurée, tel que la couche intermédiaire soit disposée entre la couche de matériau destinée à être structurée et le premier substrat, et qu'une première face de la couche intermédiaire disposée du côté de la face structurée du premier substrat soit structurée conformément à un motif inverse de celui de la face structurée du premier substrat ;
- retrait du premier substrat ;
- gravure anisotrope de la couche intermédiaire, mise en œuvre depuis la première face de la couche intermédiaire jusqu'à ce que des parties d'une face de la couche de matériau destinée à être structurée ne soient plus recouvertes par la couche intermédiaire et que des portions restantes de la couche intermédiaire forment une structure dont le motif correspond à celui de la première face de la couche intermédiaire ;
- gravure des portions restantes de la couche intermédiaire et d'au moins une partie de l'épaisseur de la couche de matériau destinée à être structurée, structurant ladite face de la couche de matériau destinée à être structurée conformément au motif de la première face de la couche intermédiaire.

Par rapport aux procédés de l'art antérieur, ce procédé ne nécessite pas la mise en œuvre d'une photolithographie en étape finale, ce qui évite d'endommager les éventuels dispositifs semi-conducteurs à proximité de la couche structurée.

De plus, aucun alignement entre les structurations réalisées et les dispositifs réalisés ensuite avec la couche de matériau structurée n'est nécessaire.

Dans tout le document, les termes « structurations » ou « structurée » font référence à la réalisation de portions en saillie par rapport à la surface sur laquelle se trouvent ces portions et formant des creux entre elles.

De manière avantageuse, la couche de matériau structurée peut comporter au moins un semi-conducteur III-V, et de préférence l'un des semi-conducteurs suivants : GaN, InGaN, AIGaN, InP, GaP, GaAs, InGaAs, AIGaS, AlGaInN, AlGaInP.

La couche de matériau structurée peut correspondre à un empilement de plusieurs couches de matériaux.

Le procédé peut être tel que :
- le premier substrat peut comporter du saphir, l'empilement de couches réalisé contre la face structurée du premier substrat peut comporter en outre une couche de détachement, comportant par exemple du nitrure, disposée entre le premier substrat et la couche intermédiaire et telle qu'une face de la couche de détachement disposée du côté de la couche intermédiaire soit structurée selon un motif similaire à celui de la face structurée du premier substrat, et la couche de détachement peut être supprimée lors du retrait par laser (LLO ou « Laser Lift-Off » en anglais) du premier substrat, ou
- le premier substrat peut comporter un semi-conducteur, ou tout autre matériau par exemple non transparent, et peut être retiré par planarisation et gravure chimique sélective vis-à-vis de la couche intermédiaire. Un matériau dit « non-transparent » correspond ici à un matériau qui n'est pas adapté pour être traversé par un laser.

En outre, le premier substrat peut correspondre à tout type de substrat pouvant être structuré et retiré tout en conservant les motifs de texturation dans la couche intermédiaire. Dans ce cas, le retrait du premier substrat peut être réalisé par la mise en œuvre d'étape(s) différente(s) d'un retrait par laser.

Le premier substrat peut correspondre à un substrat PSS.

La couche intermédiaire peut comporter de l'oxyde de semi-conducteur, par exemple du SiO₂.

De manière avantageuse, la gravure anisotrope peut être une gravure ionique réactive.

Selon une réalisation avantageuse, la face structurée du premier substrat peut comporter des portions saillantes dont les parois latérales forment, avec la surface du premier substrat sur laquelle les portions saillantes sont disposées, des angles supérieurs ou égaux à 90°, et/ou dont la forme peut être pyramidale ou conique ou tronconique ou en forme de dôme. De telles structurations ont pour avantage de faciliter le retrait du premier substrat, c'est-à-dire la désolidarisation entre le premier substrat et la couche intermédiaire.

L'empilement de couches réalisé contre la face structurée du premier substrat peut comporter en outre un deuxième substrat tel que la couche de matériau destinée à être structurée soit disposée entre le deuxième substrat et la couche intermédiaire. Ce deuxième substrat peut former, à l'issue du procédé, le support sur lequel la couche de matériau structurée est disposée.

La réalisation de l'empilement de couches contre la face structurée du premier substrat peut comporter au moins les étapes suivantes :
- réalisation d'une première partie de la couche intermédiaire contre la face structurée du premier substrat ;
- réalisation de la couche de matériau destiné à être structurée sur le deuxième substrat ;
- réalisation d'une deuxième partie de la couche intermédiaire sur ladite face de la couche de matériau destinée à être structurée ;
- solidarisation de la première partie de la couche intermédiaire à la deuxième partie de la couche intermédiaire, formant la couche intermédiaire.

Les première et deuxième parties de la couche intermédiaire peuvent comporter chacune un oxyde de semi-conducteur, et solidarisation de la première partie de la couche intermédiaire à la deuxième partie de la couche intermédiaire peut correspondre à un collage direct.

Le deuxième substrat peut comporter du saphir, ou un semi-conducteur comme par exemple du silicium.

De manière avantageuse :
- l'empilement de couches réalisé contre la face structurée du premier substrat peut comporter en outre une couche de détachement comportant par exemple du nitrure et disposée entre le premier substrat et la couche intermédiaire, et telle qu'une face de la couche de détachement disposée du côté de la couche intermédiaire soit structurée selon un motif similaire à celui de la face structurée du premier substrat ;
- la couche de détachement peut être supprimée lors du retrait du premier substrat.

Lors de la réalisation de l'empilement de couches contre la face structurée du premier substrat, la couche de matériau destinée à être structurée peut être réalisée sous forme d'îlots.

L'invention concerne également un procédé de réalisation de diodes électroluminescentes, ou LEDs, comportant la mise en œuvre d'un procédé de réalisation d'une couche de matériau structurée tel que décrit précédemment. Les structurations réalisées dans la couche de matériau servent avantageusement à augmenter l'extraction de la lumière créée dans les LEDs, notamment lorsque les LEDs comporte du GaN et/ou de l'InGaN.

Le procédé de réalisation de la couche de matériau structurée est avantageux lorsqu'il est mis en œuvre lors de la réalisation de LEDs car il permet de réaliser des structurations ayant un gain d'extraction peu dépendant de la longueur d'onde émise par les LEDs, et qui sont également adaptées à des LEDs de petites dimensions car les structurations réalisées peuvent être peu profondes.

Les structurations de la couche de matériau structurée peuvent être ordonnées ou non ordonnées. Ces structurations peuvent être diffractives ou réfractives.

La réalisation de l'empilement de couches peut comporter en outre la réalisation de jonctions p-n et de zones actives des LEDs incluant la réalisation de couches de semi-conducteur formées par épitaxie sur la couche de matériau destinée à être structurée, et la réalisation d'électrodes reliées électriquement aux jonctions p-n.

L'empilement de couches réalisé contre la face structurée du premier substrat peut comporter en outre un deuxième substrat tel que les jonctions p-n et les zones actives soient disposées entre le deuxième substrat et la couche intermédiaire, le deuxième substrat pouvant comprendre un circuit électronique de commande auquel les électrodes sont reliées.

Le procédé peut comporter en outre, entre la réalisation des électrodes et la réalisation du deuxième substrat, la mise en œuvre d'une étape de découpe de modules à LED(s) incluant chacun ou une plusieurs LEDs, un ou plusieurs modules étant ensuite solidarisés individuellement ou collectivement au deuxième substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 7 représentent les étapes d'un procédé de réalisation d'une couche de matériau structurée selon un premier mode de réalisation ;
- la figure 8 représente la structure obtenue en mettant en œuvre un procédé de réalisation d'une couche de matériau structurée selon une variante du premier mode de réalisation ;
- la figure 9 représente une structure intermédiaire obtenue lors de la mise en œuvre d'un procédé de réalisation d'une couche de matériau structurée selon une autre variante du premier mode de réalisation ;
- les figures 10 à 15 représentent les étapes d'un procédé de réalisation de diodes électroluminescente au cours duquel un procédé de réalisation d'une couche de matériau structurée selon un deuxième mode de réalisation est mis en œuvre ;
- la figure 16 représente une structure intermédiaire obtenue lors de la mise en œuvre d'un procédé de réalisation de diodes électroluminescentes au cours duquel un procédé de réalisation d'une couche de matériau structurée est mis en œuvre.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

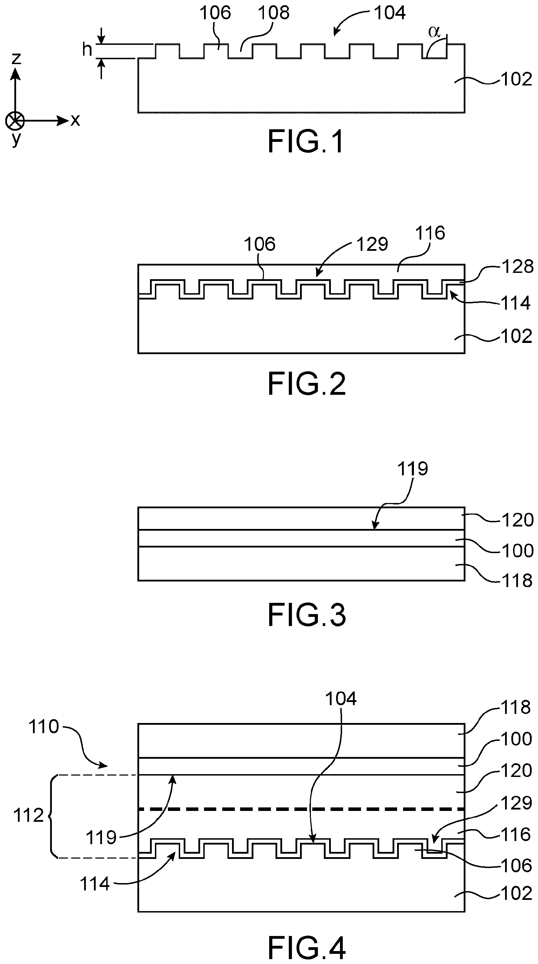

Un procédé de réalisation d'une couche de matériau 100 structurée selon un premier mode de réalisation est décrit ci-dessous en lien avec les figures 1 à 7.

Une première étape du procédé correspond à la réalisation, ou la fourniture, d'un premier substrat 102 comportant au moins une face structurée 104 (voir figure 1). Ce premier substrat 102 correspond par exemple à un substrat PSS, ou substrat de saphir structuré ou texturé. La face structurée 104 correspond ici à l'une des deux faces principales du premier substrat 102, c'est-à-dire l'une des deux faces de plus grandes dimensions du substrat 102.

Ce premier substrat 102 est par exemple circulaire et a par exemple un diamètre égal à 150 mm et une épaisseur égale à 1 mm. D'autres formes et/ou dimensions sont possibles.

La face structurée 104 du premier substrat 102 comporte des portions saillantes 106 et des creux 108 se trouvant entre ces portions saillantes 106. La hauteur « h » des portions saillantes 106, c'est-à-dire la dimension des portions saillantes 106 par rapport à la surface au niveau de laquelle se trouvent les bases des portions saillantes 106 (dimension selon l'axe Z représenté sur la figure 1), et qui correspond également à la profondeur des creux 108, est choisie en fonction de l'épaisseur de la couche de matériau 100 dans laquelle les structurations sont destinées à être réalisées ainsi que de la fonction de ces structurations (par exemple en fonction de la longueur d'onde de la lumière destinée à être extraite par ces structurations). Dans certains cas, cette hauteur « h » des portions saillantes 106 peut être inférieure ou égale à l'épaisseur de la couche de matériau 100.

Selon un exemple de réalisation particulier tel que celui représenté sur la figure 1, le motif de la face structurée 104 peut correspondre à un ou plusieurs réseaux de piliers correspondant aux portions saillantes 106, ou à un ou plusieurs réseaux de trous correspondant aux creux 108. Chaque pilier a par exemple, dans un plan parallèle à la face structurée 104 (plan parallèle au plan (X,Y) sur la figure 1), ou plan parallèle aux faces principales du premier substrat 102, une section de forme polygonale, par exemple rectangulaire ou carrée ou triangulaire, ou circulaire ou ovoïde, ou d'une autre forme. De manière avantageuse, les portions saillantes 106 ont une forme pyramidale ou conique ou tronconique ou une forme de dôme. A titre d'exemple, chaque portion saillante 106 a une forme conique de hauteur h égale à 200 nm et dont la base a un diamètre égal à 400 nm, et deux portions saillantes 106 voisines sont espacées l'une de l'autre, au niveau de leur base, d'une distance égale à 200 nm. Plus généralement, deux portions saillantes 106 voisines peuvent être espacées l'une de l'autre d'une distance sensiblement à la hauteur de ces portions saillantes 106. De manière générale, les dimensions (hauteur, diamètre, côté, espacement, etc.) des portions saillantes 106 peuvent être inférieures à 1 µm.

La ou les techniques mises en œuvre pour réaliser la face structurée 104 dépendent notamment du ou des matériaux du premier substrat 102 ainsi que de la forme et des dimensions des structurations à réaliser au niveau de la face structurée 104. Les structurations de la face structurée 104 peuvent être réalisées par exemple par lithographie électronique ou par faisceaux d'électrons, par lithographie UV, ou par lithographie par nano-impression (« nanoimprint lithography »), sans besoin d'alignement particulier sur le substrat. Lorsque ce premier substrat 102 comporte du saphir, la gravure du saphir mise en œuvre pour réaliser les structurations de la face structurée 104 peut être une gravure ionique réactive, par exemple de type ICP et mise en œuvre avec des agents de gravure comportant du chlore tels que du BCl₃.

De manière générale, les dimensions et la forme des portions saillantes 106 et des creux 108 sont choisies en fonction des propriétés recherchées pour les structurations destinées à être réalisées dans la couche de matériau 100 destinée à être structurée, c'est-à-dire de la ou des fonctions destinées à être remplies par ces structurations. Lorsque la couche de matériau 100 structurée est destinée à faire partie de LEDs, ces structurations peuvent servir avantageusement à améliorer l'extraction de la lumière émise par les LEDs. Dans ce cas, la forme, les dimensions et l'espacement entre les portions saillantes 106 sont choisis notamment en fonction de la longueur d'onde de la lumière destinée à être émise par les LEDs.

Au cours du procédé décrit ici, le premier substrat 102 est destiné à être détaché vis-à-vis d'un autre matériau réalisé du côté de la face structurée 104. Afin de faciliter ce détachement, les portions saillantes 106 sont réalisées telles que leurs parois latérales forment, avec la surface du premier substrat 102 sur laquelle les portions saillantes 106 sont disposées, des angles supérieurs ou égaux à 90°. Sur la figure 1, cet angle est désigné par la lettre « α » et est égal à 90°. Cette amélioration du détachement du premier substrat 102 est également obtenue lorsque les portions saillantes 106 ont une forme pyramidale ou conique ou tronconique ou une forme de dôme.

Un empilement 110 de couches comprenant au moins une couche intermédiaire 112 et la couche de matériau 100 destinée à être structurée est réalisé contre la face structurée 104 du premier substrat 102. Cet empilement 110 est tel que la couche intermédiaire 112 soit disposée entre la couche de matériau 100 et le premier substrat 102, et qu'une première face 114 de la couche intermédiaire 112 disposée du côté de la face structurée 104 du premier substrat 102 soit structurée conformément à un motif inverse de celui de la face structurée 104 du premier substrat 102.

Dans le premier mode de réalisation décrit ici, du fait que le premier substrat 102 correspond à un substrat de saphir destiné à être détaché par retrait laser, l'empilement 110 comporte également une couche de détachement 128 sacrificielle disposée entre le premier substrat 102 et la couche intermédiaire 112. Cette couche de détachement 128 est réalisée contre la face structurée 104 du premier substrat 102, et une première partie 116 de la couche intermédiaire 112 est réalisée contre la couche de détachement 128. La couche de détachement 128 est réalisée telle qu'une face 129 de la couche de détachement 128 disposée du côté de la couche intermédiaire 112 soit structurée selon un motif similaire à celui de la face structurée 104 du premier substrat 102. La couche de détachement 128 peut comporter un matériau à base de nitrure, comme par exemple du Si₃N₄, du GaN, de l'AlGaN, de l'AlN, etc. La première partie 116 de la couche intermédiaire 112 correspond ici à une couche d'oxyde de semi-conducteur, par exemple du SiO₂, déposée sur les portions saillantes et dans les trous formés par la couche de détachement 128 (voir figure 2). Cette première partie 116 de la couche intermédiaire 112 forme la première face 114 de la couche intermédiaire 112 disposée du côté de la face structurée 104 du premier substrat 102. Cette première face structurée 114 comporte des portions saillantes disposées dans les trous 108 de la face structurée 104 du premier substrat 102, et des trous dans lesquels les portions saillantes 106 de la face structurée du premier substrat 102 sont disposées.

Parallèlement à la réalisation de cette première partie 116 de la couche intermédiaire 112, la couche de matériau 100 est réalisée sur un deuxième substrat 118. De manière avantageuse, le matériau de la couche 100 correspond à un semi-conducteur III-V, et par exemple au moins l'un des semi-conducteurs suivants : GaN, InGaN, InP, AIGaN, AlGaInN, AlGaInP, InP, GaP, GaAs, InGaAs, AIGaS. Avantageusement, le semi-conducteur III-V de la couche 100 correspond à du GaN ou de l'InGaN, ou de l'In_{X}Ga_{(1-X)}N avec 0 ≤ X ≤ 0,5. En variante, la couche 100 pourrait comporter d'autres types de matériaux. Il est également possible que la couche 100 corresponde à un empilement de plusieurs couches de matériaux disposées les unes au-dessus des autres. De plus, dans ce premier mode de réalisation, le deuxième substrat 118 comporte du saphir. En variante, le deuxième substrat 118 peut comporter un semi-conducteur, par exemple du silicium.

Une deuxième partie 120 de la couche intermédiaire 112 est réalisée sur la couche 100, contre une face 119 de la couche 100 (voir figure 3). Comme la première partie 116, la deuxième partie 120 peut correspondre à une couche d'oxyde de semi-conducteur, par exemple du SiO₂.

Les première et deuxième parties 116, 120 sont ensuite solidarisées l'une à l'autre, par exemple par collage direct. Cette solidarisation forme la couche intermédiaire 112 (voir figure 4).

A l'issue de ces étapes, l'empilement 110 obtenu, qui comporte ici la couche de détachement 128, la couche intermédiaire 112, la couche de matériau 100 destinée à être structurée et le deuxième substrat 118, est bien disposé contre la face structurée 104 du premier substrat 102. En variante, l'empilement 110 peut comporter des couches de matériaux supplémentaires et/ou ne pas comporter le deuxième substrat 118.

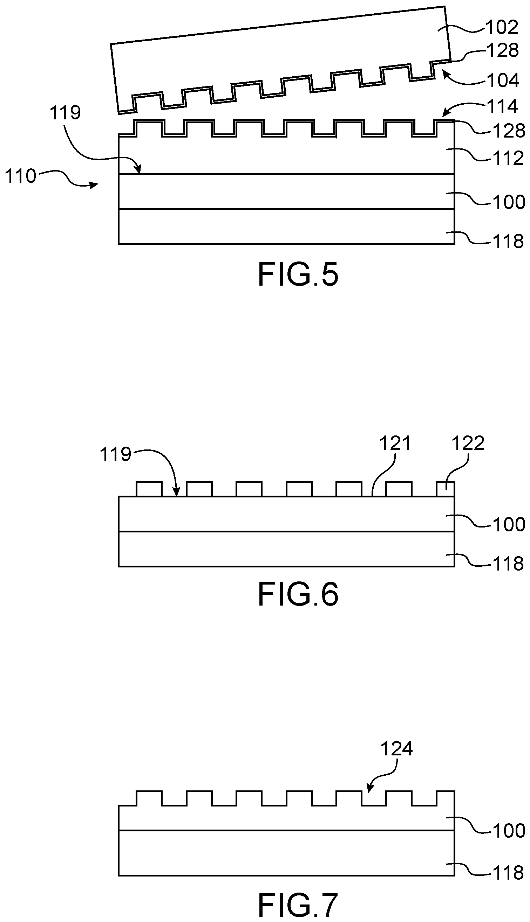

Le premier substrat 102 est ensuite retiré, c'est-à-dire désolidarisé de l'empilement 110 (voir figure 5). Dans le premier mode de réalisation décrit ici, du fait que le premier substrat 102 comporte du saphir, ce retrait est avantageusement réalisé par laser à travers le premier substrat 102. Lors de ce retrait par laser, la couche de détachement 128 absorbe le rayonnement laser et se dissocie pour permettre le détachement du premier substrat 102. Des restes de la couche de détachement 128 présents sur la couche intermédiaire 112 sont ensuite supprimés en mettant en œuvre une gravure sélective par rapport au matériau de la couche intermédiaire 112. La mise en œuvre d'un tel retrait par laser est décrite en détail par exemple dans le document FR 3 079 657 A1.

Après ce retrait, la première face structurée 114 de la couche intermédiaire 112 qui était disposée du côté de la face structurée 104 du premier substrat 102 se retrouve exposée, c'est-à-dire non recouverte par un autre matériau.

Le procédé est ensuite poursuivi afin de transférer les structurations de la première face 114 de la couche intermédiaire 112 dans la couche de matériau 100. Ce transfert est réalisé par la mise en œuvre d'une gravure anisotrope de la couche intermédiaire 112 et d'au moins une partie de l'épaisseur de la couche de matériau 100 mise en œuvre depuis la première face 114 de la couche intermédiaire 112. Cette gravure structure la face de la couche de matériau 100 se trouvant du côté de la couche intermédiaire 112 conformément au motif de la première face 114 de la couche intermédiaire 112.

Une possibilité pour réaliser un tel transfert des structurations depuis la première face 114 de la couche intermédiaire 112 jusque dans la couche de matériau 100 est de mettre en œuvre une première gravure anisotrope de la couche intermédiaire 112 depuis sa première face 114. Cette première gravure peut être stoppée lorsque des parties 121 de la face 119 de la couche de matériau 100 ne sont plus recouvertes par la couche intermédiaire 112 et que des portions restantes 122 de la couche intermédiaire 112 forment une structure dont le motif correspond à celui des structurations présentes sur la première face 114 de la couche intermédiaire 112 (voir figure 6). Cette première gravure anisotrope correspond par exemple à une gravure ionique réactive, par exemple de type ICP (« Inductively Coupled Plasma ») et utilisant un plasma fluoré tel que du CHF₃. Du fait que cette première gravure est anisotrope, les structurations présentes initialement au niveau de la première face 114 de la couche intermédiaire 112 sont bien transférées jusqu'au niveau de la couche de matériau 100.

La structuration de la couche de matériau 100 est achevée en mettant en œuvre une deuxième gravure des portions restantes 122 de la couche intermédiaire 112 et d'au moins une partie de l'épaisseur de la couche de matériau 100, à travers la face 119 de la couche de matériau 100. La mise en œuvre de cette deuxième gravure structure la face 119 de la couche de matériau 100 contre laquelle la couche intermédiaire 112 était disposée, conformément au motif de la première face 114 de la couche intermédiaire 112. La face structurée de la couche de matériau 100 obtenue porte la référence 124 sur la figure 7. Cette deuxième gravure correspond par exemple à une gravure au plasma mise en œuvre en utilisant un plasma chloré.

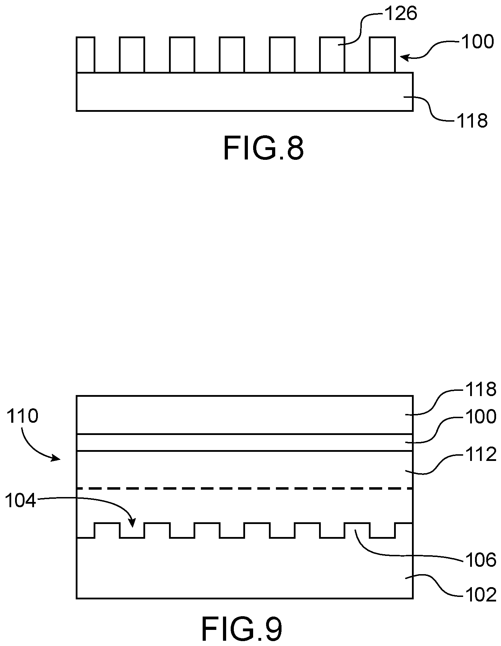

Dans le premier mode de réalisation décrit ci-dessus, les structurations de la couche de matériau 100 sont réalisées dans une partie de l'épaisseur de la couche 100. En variante, il est possible que ces structurations soient réalisées à travers toute l'épaisseur de la couche de matériau 100. Cette structuration de toute l'épaisseur de la couche de matériau 100 peut être obtenue en prolongeant la durée de mise en œuvre de la deuxième gravure précédemment décrite. La figure 8 représente la structure obtenue selon cette variante, dans laquelle la couche 100 est alors formée d'une pluralité de portions disjointes 126 disposées les unes à côté des autres et dont les dimensions, les formes et les espacements entre elles sont définis par le motif initial de la face structurée 104 du premier substrat 102. Cette variante est avantageusement mise en œuvre lorsque la couche de matériau 100 à structurer correspond à un empilement de plusieurs couches de matériaux faisant partie de LEDs.

Selon une variante du premier mode de réalisation précédemment décrit, il est possible que le premier substrat 102 soit retiré autrement que par un retrait laser. Dans ce cas, l'empilement 110 peut ne pas comporter la couche de détachement 128. Dans cette variante, la couche intermédiaire 112 est réalisée directement contre le premier substrat 102 qui peut comporter du semi-conducteur, par exemple du silicium. La figure 9 représente l'empilement 110 réalisé sur le premier substrat 102 lorsque cet empilement 110 ne comporte pas la couche de détachement 128. Dans cette variante, le premier substrat 102 est par exemple retiré en mettant tout d'abord en œuvre une planarisation depuis la face arrière du premier substrat 102, puis une gravure du matériau restant du premier substrat 102 sélective vis-à-vis du matériau de la couche intermédiaire 112.

Selon une autre variante, il est possible que lors de la réalisation de l'empilement 110, la couche de matériau 100 ne soit pas une couche continue recouvrant toute la surface de la couche intermédiaire 112, mais qu'elle soit réalisée sous la forme de plusieurs portions de matériau disjointes et disposées les unes à côté des autres sur la couche intermédiaire 112. Ces portions disjointes de la couche 100, comprenant par exemple de l'InGaN, peuvent notamment former des îlots servant à la réalisation de LEDs via la mise en œuvre d'étapes d'épitaxie, de réalisation d'interconnexions électriques, etc. Les îlots ont par exemple une section, dans un plan parallèle aux faces principales de la couche 100, de forme rectangulaire ou carrée et dont les côtés ont des dimensions comprises entre 1 mm et 1 µm. La réalisation de tels îlots permet d'obtenir de l'InGaN relaxé, c'est-à-dire non contraint.

Les différentes variantes décrites ci-dessus ne sont pas exclusives les unes des autres et plusieurs de ces variantes peuvent être mises en œuvre au cours d'un même procédé de structuration de la couche 100.

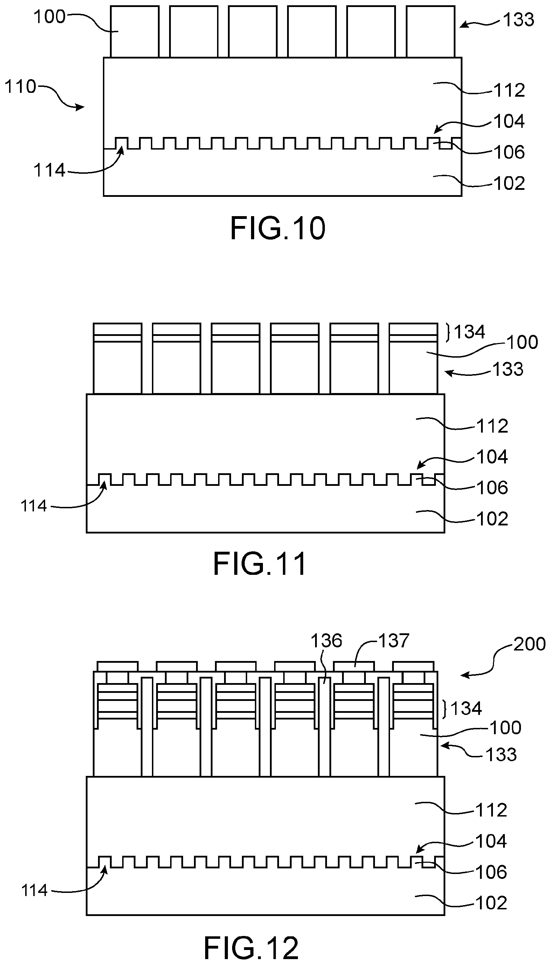

Un procédé de réalisation de LEDs 200, au cours duquel un procédé de réalisation de la couche de matériau 100 structurée selon un deuxième mode de réalisation est mis en œuvre, est décrit ci-dessous en lien avec les figures 10 à 15.

Comme dans le premier mode de réalisation précédemment décrit, l'empilement 110 est réalisé contre la face structurée 104 du premier substrat 102. Sur la figure 10, l'empilement 110 comporte la couche intermédiaire 112 et la couche 100 qui comporte ici de l'InGaN. La couche 100 est ici réalisée sous la forme de plusieurs portions de matériau 133 disjointes, par exemple de forme et de dimensions identiques aux îlots précédemment décrits en lien avec le premier mode de réalisation. Toutefois, en variante de ce deuxième mode de réalisation, la couche 100 peut être réalisée sous la forme d'une couche continue. La structure représentée sur la figure 10 est par exemple obtenue en mettant en œuvre le procédé décrit dans le document FR 3 056 825 A1, en utilisant un substrat 102 structuré. Selon une autre variante, l'empilement 110 peut comporter d'autres couches de matériaux.

Une ou plusieurs autres couches 134 de matériaux semi-conducteurs destinées à former, avec la couche 100, des jonctions p-n des LEDs 200 ainsi que les zones actives des LEDs 200 sont réalisées sur la couche 100, c'est-à-dire sur chacune des portions disjointes 133 formant ensemble la couche 100 (voir figure 11). Ces couches sont par exemple réalisées en mettant en œuvre des étapes de report et d'épitaxie. Comme la couche 100, la ou les couches 134 sont réalisées sous la forme de plusieurs portions de matériau disjointes sur les portions 133.

Des électrodes 136, 137 sont ensuite réalisées telles qu'elles soient en contact électriquement avec les portions de semi-conducteur dopées n et p des couches 100 et 134, formant les anodes et les cathodes des LEDs 200 (voir figure 12).

Les couches 100, 134 et les électrodes 136, 137 sont par exemple réalisées conformément à la réalisation décrite dans le document EP 3 365 924 A1. Selon une variante de réalisation, l'une des deux électrodes 136, 137 de chaque LED 200, par exemple la cathode, peut être commune à toutes les LEDs 200 réalisées sur le premier substrat 102.

Chaque empilement de semi-conducteur réalisé sur une des portions disjointes de la couche 100 peut former une LED 200. En variante, il est possible de réaliser une segmentation ou division, par exemple par gravure, dans chacun de ces empilements afin de former, à partir de chacun de ces empilements, plusieurs LEDs 102 de plus petites dimensions. Par exemple, si chaque portion disjointe de la couche 100 comporte un côté de dimension égale à 500 µm, chaque empilement semi-conducteur formé sur chacune de ces portions peut être segmenté ou divisé en plusieurs parties disjointes comportant chacune un côté de dimension inférieure à celle des portions initiales, par exemple égale à 10 µm.

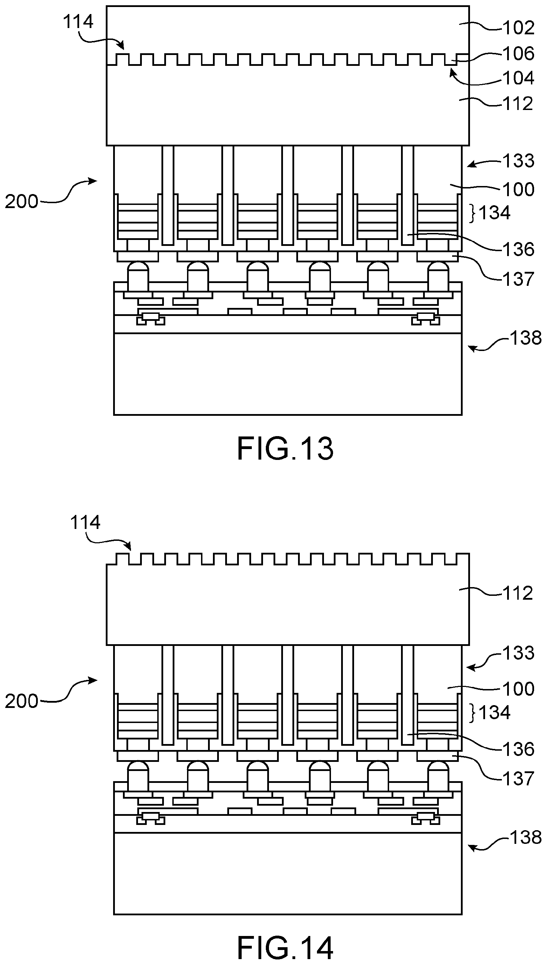

L'ensemble précédemment réalisé est ensuite reporté sur un deuxième substrat 138 qui correspond ici à un circuit électronique de commande des LEDs 200 (voir figure 13) destiné à l'adressage passif ou actif des LEDs 200. La solidarisation entre ce circuit électronique de commande et les électrodes 136, 137 des LEDs 200 est par exemple obtenue par un procédé d'hybridation de type Flip chip (puce retournée) avec des billes de brasure Sn-Ag par exemple, ou tout autre moyen d'interconnexion flip chip largement décrit dans la littérature. Le report sur ce circuit électronique de commande inclut la réalisation de liaisons électriques et mécaniques entre les LEDs 200 et le circuit électronique de commande. Sur la figure 13, seules les liaisons électriques entre les électrodes 137 et le circuit électronique de commande sont visibles.

En variante, il est possible que les LEDs 200 soient découpées individuellement ou par groupes, ou modules, de plusieurs LEDs 200, puis reportées ensuite sur le circuit électronique de commande.

Comme dans le premier mode de réalisation, le premier substrat 102 est ensuite retiré et désolidarisé de la couche intermédiaire 112, révélant la face structurée 114 de la couche intermédiaire 112 (voir figure 14). Comme dans le premier mode de réalisation, lorsque ce retrait est réalisé au moyen d'un laser, une couche de détachement 128 est interposée entre le premier substrat 102 et la couche intermédiaire 112 lors de la réalisation l'empilement 110.

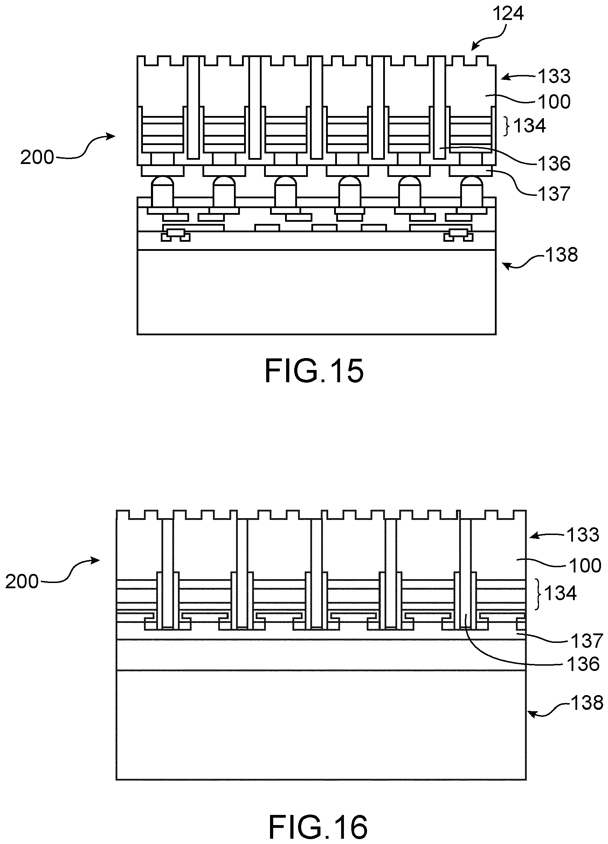

Le procédé est achevé comme dans le premier mode de réalisation, c'est-à-dire en mettant en œuvre une gravure anisotrope de la couche intermédiaire 112 et d'au moins une partie de l'épaisseur de la couche 100 dans laquelle les structurations sont transférées, depuis la première face 114 de la couche intermédiaire 112 (voir figure 15). La face gravée de la couche 100 porte la référence 124. Cette gravure comporte par exemple la mise en œuvre des première et deuxième gravures similaires à celles précédemment décrites en lien avec le premier mode de réalisation.

Les LEDs 200 réalisées peuvent comporter leur anode et cathode se trouvant du même côté, c'est-à-dire du côté du circuit de commande. En variante, il est possible que les LEDs 200 comportent une première de leurs deux électrodes, par exemple leur anode, du côté du circuit commande, et leur deuxième électrode, par exemple leur cathode, du côté opposé, c'est-à-dire du côté de leur face émissive. Dans ce cas, les structurations peuvent être réalisées à travers au moins une partie de l'épaisseur de cette deuxième électrode. De telles diodes sont appelées diodes VTF (« Vertical Thin Film »). Un exemple de réalisation de telles diodes est représenté sur la figure 16. Sur cet exemple, les structurations sont réalisées dans la couche 100. De plus, sur l'exemple de la figure 16, les anodes sont communes à toutes les LEDs 200.

## Revendications

1. Procédé de réalisation d'au moins une couche de matériau (100) structurée, comprenant au moins les étapes suivantes :
- réalisation d'un premier substrat (102) comportant au moins une face structurée (104) ;
- réalisation, contre la face structurée (104) du premier substrat (102), d'un empilement de couches (110) comprenant au moins une couche intermédiaire (112) et la couche de matériau (100) destinée à être structurée, tel que la couche intermédiaire (112) soit disposée entre la couche de matériau (100) destinée à être structurée et le premier substrat (102), et qu'une première face (114) de la couche intermédiaire (112) disposée du côté de la face structurée (104) du premier substrat (102) soit structurée conformément à un motif inverse de celui de la face structurée (104) du premier substrat (102) ;
- retrait du premier substrat (102) ;
- gravure anisotrope de la couche intermédiaire (112), mise en œuvre depuis la première face (114) de la couche intermédiaire (112) jusqu'à ce que des parties (121) d'une face (119) de la couche de matériau (100) destinée à être structurée ne soient plus recouvertes par la couche intermédiaire (112) et que des portions restantes (122) de la couche intermédiaire (112) forment une structure dont le motif correspond à celui de la première face (114) de la couche intermédiaire (112) ;
- gravure des portions restantes (122) de la couche intermédiaire (112) et d'au moins une partie de l'épaisseur de la couche de matériau (100) destinée à être structurée, structurant ladite face (119, 124) de la couche de matériau (100) destinée à être structurée conformément au motif de la première face (114) de la couche intermédiaire (112).

2. Procédé selon la revendication 1, dans lequel la couche de matériau (100) destinée à être structurée comporte au moins un semi-conducteur III-V, et de préférence l'un des semi-conducteurs suivants : GaN, InGaN, InP, AIGaN, GaP, GaAs, InGaAs, AIGaS, AlGaInN, AlGaInP.

3. Procédé selon la revendication 1, dans lequel la couche de matériau (100) destinée à être structurée correspond à un empilement de plusieurs couches de matériaux.

4. Procédé selon l'une des revendications précédentes, dans lequel :
- le premier substrat (102) comporte du saphir, l'empilement (110) de couches réalisé contre la face structurée (104) du premier substrat (102) comporte en outre une couche de détachement (128) disposée entre le premier substrat (102) et la couche intermédiaire (112) et telle qu'une face (129) de la couche de détachement (128) disposée du côté de la couche intermédiaire (112) soit structurée selon un motif similaire à celui de la face structurée (104) du premier substrat (102), et la couche de détachement (128) est supprimée lors du retrait par laser du premier substrat (102), ou
- le premier substrat (102) comporte un semi-conducteur ou un matériau non transparent et est retiré par planarisation et gravure chimique sélective vis-à-vis de la couche intermédiaire (112).

5. Procédé selon l'une des revendications précédentes, dans lequel la gravure anisotrope est une gravure ionique réactive.

6. Procédé selon l'une des revendications précédentes, dans lequel la face structurée (104) du premier substrat (102) comporte des portions saillantes (106) dont les parois latérales forment, avec la surface du premier substrat (102) sur laquelle les portions saillantes (106) sont disposées, des angles supérieurs ou égaux à 90°, et/ou dont la forme est pyramidale ou conique ou tronconique ou en forme de dôme.

7. Procédé selon l'une des revendications précédentes, dans lequel l'empilement de couches (110) réalisé contre la face structurée (104) du premier substrat (102) comporte en outre un deuxième substrat (118, 138) tel que la couche de matériau (100) destinée à être structurée soit disposée entre le deuxième substrat (118, 138) et la couche intermédiaire (112).

8. Procédé selon la revendication 7, dans lequel la réalisation de l'empilement de couches (110) contre la face structurée (104) du premier substrat (102) comporte au moins les étapes suivantes :
- réalisation d'une première partie (116) de la couche intermédiaire (112) contre la face structurée (104) du premier substrat (102) ;
- réalisation de la couche de matériau (100) destinée à être structurée sur le deuxième substrat (118, 138) ;
- réalisation d'une deuxième partie (120) de la couche intermédiaire (112) sur ladite face (119) de la couche de matériau (100) destinée à être structurée ;
- solidarisation de la première partie (116) de la couche intermédiaire (112) à la deuxième partie (120) de la couche intermédiaire (112), formant la couche intermédiaire (112).

9. Procédé selon la revendication 8, dans lequel les première et deuxième parties (116, 120) de la couche intermédiaire (112) comporte chacune un oxyde de semi-conducteur, et dans lequel la solidarisation de la première partie (116) de la couche intermédiaire (112) à la deuxième partie (120) de la couche intermédiaire (112) correspond à un collage direct.

10. Procédé selon l'une des revendications précédentes, dans lequel, lors de la réalisation de l'empilement (110) de couches contre la face structurée (104) du premier substrat (102), la couche de matériau (100) destinée à être structurée est réalisée sous forme d'îlots (133).

11. Procédé de réalisation de diodes électroluminescentes (200), comportant la mise en œuvre d'un procédé de réalisation d'une couche de matériau structurée (100) selon l'une des revendications précédentes.

12. Procédé selon la revendication 11, dans lequel la réalisation de l'empilement (110) de couches comporte en outre la réalisation de jonctions p-n et de zones actives des diodes électroluminescentes (200) incluant la réalisation de couches de semi-conducteur (134) formées par épitaxie sur la couche de matériau (100) destinée à être structurée, et la réalisation d'électrodes (136, 137) reliées électriquement aux jonctions p-n.

13. Procédé selon la revendication 12, dans lequel l'empilement (110) de couches réalisé contre la face structurée (104) du premier substrat (102) comporte en outre un deuxième substrat (138) tel que les jonctions p-n et les zones actives soient disposées entre le deuxième substrat (138) et la couche intermédiaire (112), le deuxième substrat (138) comprenant un circuit électronique de commande auquel les électrodes (136, 137) sont reliées.

14. Procédé selon la revendication 13, comportant en outre, entre la réalisation des électrodes (136, 137) et la réalisation du deuxième substrat (138), la mise en œuvre d'une étape de découpe de modules à diode(s) électroluminescente(s) (200) incluant chacun une ou plusieurs diodes électroluminescentes (200), un ou plusieurs modules étant ensuite solidarisés individuellement ou collectivement au deuxième substrat (138).

## Patentansprüche

1. Verfahren zum Aufbringen von mindestens einer strukturierten Materialschicht (100), mindestens die folgenden Schritte umfassend:
- Aufbringen von einem ersten Substrat (102), mindestens eine strukturierte Fläche (104) beinhaltend;
- Aufbringen, gegen die strukturierte Fläche (104) des ersten Substrats (102), eines Schichtstapels (110), der mindestens eine Zwischenschicht (112) umfasst und die Materialschicht (100), die dazu bestimmt ist, strukturiert zu werden, so dass die Zwischenschicht (112) zwischen der Materialschicht (100), die dazu bestimmt ist, strukturiert zu werden, und dem ersten Substrat (102) angeordnet ist, und dass eine erste Fläche (114) der Zwischenschicht (112), die auf der Seite der strukturierten Fläche (104) des ersten Substrats (102) angeordnet ist, gemäß einem Muster strukturiert ist, das umgekehrt zur strukturierten Fläche (104) des ersten Substrats (102) ist;
- Entfernen des ersten Substrats (102);
- anisotropes Ätzen der Zwischenschicht (112), ausgeführt von der ersten Fläche (114) der Zwischenschicht (112) ausgehend, bis dass Bereiche (121) einer Fläche (119) der Materialschicht (100), die dazu bestimmt ist, strukturiert zu werden, nicht mehr durch die Zwischenschicht (112) bedeckt sind und dass verbleibende Abschnitte (122) der Zwischenschicht (112) eine Struktur bilden, deren Muster dem der ersten Fläche (114) der Zwischenschicht (112) entspricht;
- Ätzen der verbleibenden Abschnitte (122) der Zwischenschicht (112) und mindestens eines Bereichs der Dicke der Materialschicht (100), die dazu bestimmt ist, strukturiert zu werden, wobei die Fläche (119, 124) der Materialschicht (100), die dazu bestimmt ist, strukturiert zu werden, gemäß dem Muster der ersten Fläche (114) der Zwischenschicht (112) strukturiert wird.

2. Verfahren nach Anspruch 1, wobei die Materialschicht (100), die dazu bestimmt ist, strukturiert zu werden, mindestens einen III-V-Halbleiter beinhaltet, und vorzugsweise einen der folgenden Halbleiter: GaN, InGaN, InP, AIGaN, GaP, GaAs, InGaAs, AIGaS, AIGalnN, AIGalnP.

3. Verfahren nach Anspruch 1, wobei die Materialschicht (100), die dazu bestimmt ist, strukturiert zu werden, einem Stapel mit mehreren Materialschichten entspricht.

4. Verfahren nach einem der vorhergehenden Ansprüche, wobei:
- das erste Substrat (102) Saphir beinhaltet, der gegen die strukturierte Fläche (104) des ersten Substrats (102) aufgebrachte Schichtstapel (110) beinhaltet ferner eine zwischen dem ersten Substrat (102) und der Zwischenschicht (112) angeordnete Trennschicht (128), und so dass eine Fläche (129) der Trennschicht (128), die auf der Seite der Zwischenschicht (112) angeordnet ist, gemäß einem Muster strukturiert ist, das dem der strukturierten Fläche (104) des ersten Substrats (102) ähnlich ist, und die Trennschicht (128) wird während der Entfernung des ersten Substrats (102) durch Laser beseitigt, oder
- das erste Substrat (102) einen Halbleiter oder ein nicht-transparentes Material beinhaltet und wird durch Planarisierung und selektives chemisches Ätzen der Zwischenschicht (112) gegenüberliegend entfernt.

5. Verfahren nach einem der vorhergehenden Ansprüche, wobei das anisotrope Ätzen ein plasma-unterstütztes Ätzen ist.

6. Verfahren nach einem der vorhergehenden Ansprüche, wobei die strukturierte Fläche (104) des ersten Substrats (102) vorstehende Abschnitte (106) beinhaltet, deren Seitenwände zusammen mit der Oberfläche des ersten Substrats (102), auf der die vorstehenden Abschnitte (106) angeordnet sind, Winkel größer oder gleich 90° bilden und/oder deren Form pyramidenförmig oder kegelförmig ist oder kegelstumpfförmig oder kuppelförmig.

7. Verfahren nach einem der vorhergehenden Ansprüche, bei dem der Schichtstapel (110), der gegen die strukturierte Fläche (104) des ersten Substrats (102) aufgebracht ist, ferner ein zweites Substrat (118, 138) beinhaltet, so dass die Materialschicht (100), die dazu bestimmt ist, strukturiert zu werden, zwischen dem zweiten Substrat (118, 138) und der Zwischenschicht (112) angeordnet ist.

8. Verfahren nach Anspruch 7, wobei das Aufbringen des Schichtstapels (110) gegen die strukturierte Fläche (104) des ersten Substrats (102) mindestens die folgenden Schritte beinhaltet:
- Aufbringen eines ersten Bereichs (116) der Zwischenschicht (112) gegen die strukturierte Fläche (104) des ersten Substrats (102);
- Aufbringen der Materialschicht (100), die dazu bestimmt ist, strukturiert zu werden, auf dem zweiten Substrat (118, 138);
- Aufbringen eines zweiten Bereichs (120) der Zwischenschicht (112) auf der Fläche (119) der Materialschicht (100), die dazu bestimmt ist, strukturiert zu werden;
- Zusammenfügen des ersten Bereichs (116) der Zwischenschicht (112) mit dem zweiten Bereich (120) der Zwischenschicht (112), wodurch die Zwischenschicht (112) gebildet wird.

9. Verfahren nach Anspruch 8, wobei der erste und der zweite Bereich (116, 120) der Zwischenschicht (112) jeweils ein Halbleiteroxid beinhalten, und wobei das Zusammenfügen des ersten Bereichs (116) der Zwischenschicht (112) mit dem zweiten Bereich (120) der Zwischenschicht (112) einer direkten Verklebung entspricht.

10. Verfahren nach einem der vorhergehenden Ansprüche, wobei während dem Aufbringen des Schichtstapels (110) gegen die strukturierte Fläche (104) des ersten Substrats (102), die Materialschicht (100), die dazu bestimmt ist, strukturiert zu werden, in Form von Inseln (133) aufgebracht wird.

11. Verfahren zum Aufbringen von Leuchtdioden (200), die Ausführung eines Verfahrens zum Aufbringen einer strukturierten Materialschicht (100) beinhaltend, nach einem der vorhergehenden Ansprüche.

12. Verfahren nach Anspruch 11, wobei das Aufbringen des Schichtstapels (110) ferner das Aufbringen von p-n-Übergängen und von aktiven Zonen der Leuchtdioden (200) beinhaltet, einschließlich dem Aufbringen von Halbleiterschichten (134), die durch Epitaxie auf der Materialschicht (100), die dazu bestimmt ist, strukturiert zu werden, gebildet werden, und dem Aufbringen von Elektroden (136, 137), die elektrisch mit den p-n-Übergängen verbunden sind.

13. Verfahren nach Anspruch 12, wobei der Schichtstapel (110), der gegen die strukturierte Fläche (104) des ersten Substrats (102) aufgebracht ist, ferner ein zweites Substrat (138) beinhaltet, so dass die p-n-Übergänge und die aktiven Zonen zwischen dem zweiten Substrat (138) und der Zwischenschicht (112) angeordnet sind, wobei das zweite Substrat (138) eine elektronische Steuerschaltung umfasst, mit der die Elektroden (136, 137) verbunden sind.

14. Verfahren nach Anspruch 13, ferner zwischen dem Aufbringen der Elektroden (136, 137) und dem Aufbringen des zweiten Substrats (138) die Ausführung eines Schritts des Zuschneidens von Modulen mit Leuchtdiode(n) (200) beinhaltend, die jeweils eine oder mehrere Leuchtdioden (200) einschließen, wobei anschließend ein oder mehrere Module einzeln oder gemeinsam mit dem zweiten Substrat (138) zusammengefügt werden.

## Claims

1. Method for producing at least one patterned layer of material (100), comprising at least the following steps of:
- producing a first substrate (102) having at least one patterned face (104);
- producing, against the patterned face (104) of the first substrate (102), a stack of layers (110) comprising at least one intermediate layer (112) and the layer of material (100) intended to be patterned, such that the intermediate layer (112) is disposed between the layer of material (100) intended to be patterned and the first substrate (102), and such that a first face (114) of the intermediate layer (112) disposed on the patterned face (104) side of the first substrate (102) is patterned in accordance with a design that is the inverse of that of the patterned face (104) of the first substrate (102);
- removing the first substrate (102);
- anisotropic etching the intermediate layer (112), implemented from the first face (114) of the intermediate layer (112) until parts (121) of a face (119) of the layer of material (100) intended to be patterned are no longer covered by the intermediate layer (112) and until remaining portions (122) of the intermediate layer (112) form a pattern, the design whereof corresponds to that of the first face (114) of the intermediate layer (112);
- etching the remaining portions (122) of the intermediate layer (112) and at least part of the thickness of the layer of material (100) intended to be patterned, patterning said face (119, 124) of the layer of material (100) intended to be patterned in accordance with the design of the first face (114) of the intermediate layer (112).

2. Method according to claim 1, wherein the layer of material (100) intended to be patterned contains at least one III-V semiconductor, and preferably one of the following semiconductors: GaN, InGaN, InP, AIGaN, GaP, GaAs, InGaAs, AIGaS, AlGaInN, or AlGaInP.

3. Method according to claim 1, wherein the layer of material (100) intended to be patterned corresponds to a stack of a plurality of layers of materials.

4. Method according to one of previous claims, wherein:
- the first substrate (102) contains sapphire, the stack (110) of layers produced against the patterned face (104) of the first substrate (102) further includes a release layer (128) disposed between the first substrate (102) and the intermediate layer (112) and such that a face (129) of the release layer (128) disposed on the intermediate layer (112) side is patterned according to a design that is similar to that of the patterned face (104) of the first substrate (102), and the release layer (128) is removed when the first substrate (102) is removed by laser lift-off, or
- the first substrate (102) contains a semiconductor or a non-transparent material, and is removed by planarization and chemical etching that is selective relative to the intermediate layer (112).

5. Method according to one of previous claims, wherein the anisotropic etching process is a reactive-ion etching process.

6. Method according to one of previous claims, wherein the patterned face (104) of the first substrate (102) has protruding portions (106), the side walls whereof form, with the surface of the first substrate (102) on which the protruding portions (106) are disposed, angles of greater than or equal to 90°, and/or the shape whereof is pyramidal or conical or frustoconical or dome-shaped.

7. Method according to one of previous claims, wherein the stack of layers (110) produced against the patterned face (104) of the first substrate (102) further includes a second substrate (118, 138) such that the layer of material (100) intended to be patterned is disposed between the second substrate (118, 138) and the intermediate layer (112).

8. Method according to claim 7, wherein the production of the stack of layers (110) against the patterned face (104) of the first substrate (102) includes at least the following steps of:
- producing a first part (116) of the intermediate layer (112) against the patterned face (104) of the first substrate (102);
- producing the layer of material (100) intended to be patterned on the second substrate (118, 138);
- producing a second part (120) of the intermediate layer (112) on said face (119) of the layer of material (100) intended to be patterned;
- rigidly connecting the first part (116) of the intermediate layer (112) to the second part (120) of the intermediate layer (112), forming the intermediate layer (112).

9. Method according to claim 8, wherein the first and second parts (116, 120) of the intermediate layer (112) each contain a semiconductor oxide, and wherein the rigid connection of the first part (116) of the intermediate layer (112) to the second part (120) of the intermediate layer (112) corresponds to direct bonding.

10. Method according to one of previous claims, wherein, during the production of the stack (110) of layers against the patterned face (104) of the first substrate (102), the layer of material (100) intended to be patterned is produced in the form of islands (133).

11. Method for producing electroluminescent diodes (200), including the implementation of a method for producing a patterned layer of material (100) according to one of previous claims.

12. Method according to claim 11, wherein the production of the stack (110) of layers further includes the production of p-n junctions and active regions of the electroluminescent diodes (200) including the production of semiconductor layers (134) formed by epitaxy on the layer of material (100) intended to be patterned, and the production of electrodes (136, 137) electrically connected to the p-n junctions.

13. Method according to claim 12, wherein the stack (110) of layers produced against the patterned face (104) of the first substrate (102) further includes a second substrate (138) such that the p-n junctions and the active regions are disposed between the second substrate (138) and the intermediate layer (112), the second substrate (138) comprising an electronic control circuit to which the electrodes are connected.

14. Method according to claim 13, further including, between the production of the electrodes (136, 137) and the production of the second substrate(138), the implementation of a step of cutting electroluminescent diode (200) modules, each including one or more electroluminescent diodes (200), one or more modules then being individually or collectively rigidly connected to the second substrate (138).
